# EUROPEAN PATENT APPLICATION

(11) **EP 4 632 811 A1**
(43) Date of publication of application: **15.10.2025**
(21) Application number: 25162847.5
(22) Date of filing: 11.03.2025
(51) Int. Cl.: H01L 23/528, H01L 21/768, H10D 62/10, H10D 64/23, H10D 84/01

(54) **SEMICONDUCTOR DEVICE INCLUDING BACKSIDE CONTACT AND METHOD OF FORMING THE SEMICONDUCTOR DEVICE**

(30) Priority: 10.04.2024 US 202463632043 P; 13.08.2024 US 202418802021
(71) Applicant: SAMSUNG ELECTRONICS CO., LTD., Yeongtong-gu Suwon-si, Gyeonggi-do 16677 (KR)
(72) Inventor: LEE, Jongjin, 16677 Suwon-si, Gyeonggi-do (KR); KIM, Byounghoon, 16677 Suwon-si, Gyeonggi-do (KR); CHUNG, Wonkeun, 16677 Suwon-si, Gyeonggi-do (KR); SEO, Kang-Ill, 16677 Suwon-si, Gyeonggi-do (KR)
(74) Representative: Kuhnen & Wacker Patent- und Rechtsanwaltsbüro PartG mbB

(57) **Abstract**

Semiconductor devices are provided. A semiconductor device (110) includes a source/drain, S/D, region (140). The semiconductor device (110) includes a backside, BS, contact (150, 150a, 150b) that includes an upper surface that is on a lower surface of the S/D region (140). Moreover, the semiconductor device includes a BS power rail (160) that is on a lower surface of the BS contact and is electrically connected to the S/D region (140) by the BS contact (150, 150a, 150b). The lower surface of the BS contact (150, 150a, 150b) is wider than the upper surface of the BS contact (150, 150a, 150b). Related methods of forming semiconductor devices are also provided.

## Description

### TECHNICAL FIELD

The present disclosure generally relates to the field of semiconductor devices and, more particularly, to semiconductor devices having backside (BS) contacts.

### BACKGROUND OF THE INVENTION

Integrated circuit (IC) devices, chips, and/or blocks may receive power and data signals from one or more external sources (e.g., a power source and a data source) as part of an operation. Some IC devices may receive power and data signals via front-side (FS) conductive structures. For example, an IC device may include an FS power distribution network (FSPDN) having one or more components that are formed during back-end-of-line (BEOL) processes, and conductive structures for data signals may be on the same side of an IC device as the FSPDN. IC devices may include various transistor structures, including, for example, two-dimensional (2D) planar structures, fin field-effect transistors (FinFETs), gate-all-around transistors, multi-bridge channel FETs (MBCFETs^{™}), and stacked transistors (e.g., three-dimensional (3D) stacked transistors).

More recently, backside PDNs (BSPDNs), in which a BS of an IC device is used as a PDN, have also been developed. For example, a power rail may be used in a BSPDN of an IC device, and may be on a side of the IC device (e.g., a side of a substrate of the IC device) opposite from active components (e.g., transistors) of the IC device. Moreover, conductive structures for data signals may be on an FS of the IC device, and thus the BSPDN and the conductive structures for the data signals may be on opposite sides of the IC device.

### SUMMARY OF THE INVENTION

A semiconductor device, according to some embodiments herein, may include a source/drain (S/D) region. The semiconductor device may include a BS contact that includes an upper surface that is on a lower surface of the S/D region. Moreover, the semiconductor device may include a BS power rail that is on a lower surface of the BS contact and is electrically connected to the S/D region by the BS contact. The lower surface of the BS contact may be wider than the upper surface of the BS contact.

A semiconductor device, according to some embodiments herein, may include an S/D region. The semiconductor device may include a BSPDN including a power line that is electrically connected to the S/D region. The semiconductor device may include a BS contact that is coupled between the S/D region and the power line. The semiconductor device may include an isolation region that is on a sidewall of an upper portion of the BS contact and a side surface of a lower portion of the BS contact. A width of the lower portion of the BS contact may increase as the lower portion of the BS contact approaches the power line. Moreover, the semiconductor device may include a dielectric spacer that is between the isolation region and the sidewall of the upper portion of the BS contact.

In an exemplary embodiment, the side surface of the lower portion of the BS contact may be in contact with the isolation region, and the semiconductor device may further comprise a semiconductor buffer layer that is between the S/D region and the BS contact and on a sidewall of the dielectric spacer.

A method of forming a semiconductor device, according to some embodiments herein, may include etching a sacrificial layer having a stack of channel layers thereon. A closest one of the channel layers to the sacrificial layer may be a dummy channel layer. Etching the sacrificial layer may include forming an opening in the sacrificial layer that narrows in width as the sacrificial layer approaches the dummy channel layer. The method may include forming a sacrificial contact in the opening. The method may include replacing the sacrificial layer with an isolation region, after forming the sacrificial contact. The method may include replacing the sacrificial contact with a conductive contact. Moreover, the method may include forming a BS power rail on the sacrificial contact.

In an exemplary embodiment the method may further comprise: forming a sidewall spacer on sidewalls of the channel layers, before etching the sacrificial layer; and removing the sidewall spacer from the sidewalls of the channel layers except for the dummy channel layer.

In an exemplary embodiment the method may further comprise: forming a semiconductor buffer layer on the sacrificial contact; and forming a source/drain, S/D, region on the semiconductor buffer layer.

In an exemplary embodiment the method may further comprise etching the channel layers while using the sacrificial layer as an etch-stop layer, before etching the sacrificial layer, wherein the sacrificial layer is thicker than any layer between the sacrificial layer and a farthest one of the channel layers from the sacrificial layer.

### BRIEF DESCRIPTION OF THE DRAWINGS

FIG. 1A is a schematic block diagram of a semiconductor device according to some embodiments herein.
FIG. 1B is a schematic block diagram of the IC of FIG. 1A.
FIG. 1C is an example cross-sectional view of the IC of FIG. 1B.
FIG. 1D is an enlarged view of a portion of FIG. 1C.
FIGs. 2A-2Q are cross-sectional views illustrating operations of forming the structure shown in FIG. 1C.
FIG. 3 is a flowchart corresponding to the operations shown in FIGs. 2A-2Q.

### DETAILED DESCRIPTION

To improve power rail effectiveness and voltage drop (i.e., IR drop), BSPDN structures have been developed. BSPDN structures may be formed on the BS of a semiconductor chip (or IC device) rather than on the FS. The BSPDN structure may include a power delivery network that includes one or more power rails. Different ways to connect from the FS to the BS include, for example, a front via BS power rail (FV-BPR) and a direct BS contact (DBC). The DBC may be more effective in terms of process capability and dimension limitations than other ways of connecting the FS to the BS. As contacted poly pitch (CPP) is becoming smaller, however, DBCs are becoming more difficult to form due to patterning issues such as photo overlay and high aspect ratio etch process (which may result in voids in the DBCs).

Pursuant to embodiments herein, semiconductor (e.g., semiconductor IC) devices are provided that have a structure that includes an improved DBC. The structure, which includes a BSPDN and does not include a bottom dielectric isolation (BDI) layer, may advantageously be used in IC devices having a relatively narrow CPP. In some embodiments, CPP may refer to a spacing between adjacent gates or gate contacts. The omission of the BDI layer may improve alignment of the DBC and may allow the DBC to have a positive etch slope for a contact fill material (e.g., metal). For example, the DBC may be fully aligned and may be free of voids. As used herein, the term "fully aligned" may refer to alignment with an overlying S/D region such that an entirety of an upper surface of the DBC is overlapped by the S/D region in a vertical direction. The upper surface of the DBC may thus be adjacent, and may face, the S/D region. Moreover, a dielectric material barrier may be on a sidewall of an upper portion of the DBC, and may thereby inhibit/prevent an electrical short between the DBC and a nearby gate. Furthermore, a semiconductor blocking layer may, according to some embodiments, be between the DBC and the overlying S/D region.

Some examples of embodiments of the present disclosure will be described in greater detail with reference to the attached figures.

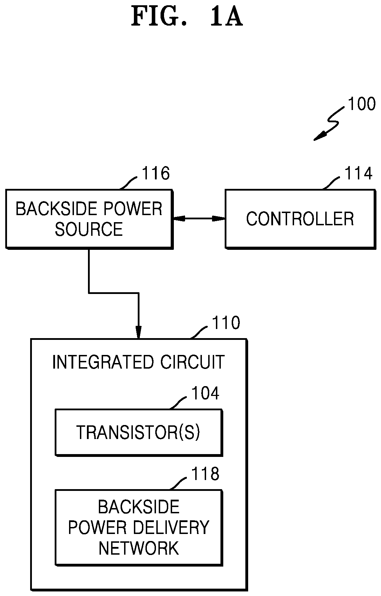

FIG. 1A is a schematic block diagram of a semiconductor device 100 according to some embodiments herein. The semiconductor device 100 includes an IC 110, which has one or more transistors 104, and a BSPDN 118. For example, a transistor 104 may be a nanosheet transistor that includes a stack of nanosheet layers.

The semiconductor device 100 also includes a BS power source 116 that is coupled to the IC 110. The BS power source 116 may provide power signals to the IC 110 at one or more voltage levels. As an example, the BS power source 116 may be configured to provide one or more voltages between 0.4-1.1 volts to the BSPDN 118.

The semiconductor device 100 further includes a controller 114 that is coupled to the BS power source 116. The controller 114 may include one or more microprocessors that are configured to control operations of the BS power source 116. For example, the controller 114 may include a microprocessor that is configured to turn the BS power source 116 on or off. The controller 114 and the BS power source 116 may be used to perform chip-level power gating (e.g., turning on or off the entire IC 110) and/or block-level power gating (e.g., turning on or off individual portions of the IC 110, such as the transistor(s) 104). As shown in FIG. 1A, the controller 114 may be external to (i.e., outside of) the IC 110 that includes the transistor(s) 104.

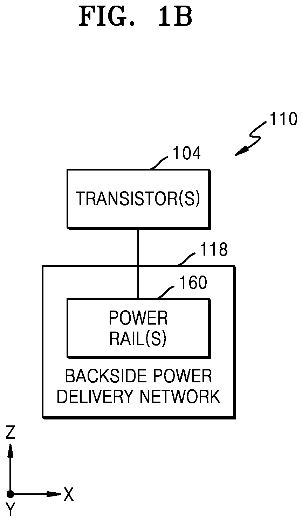

FIG. 1B is a schematic block diagram of the IC 110. As shown in FIG. 1B, the IC 110 includes the BSPDN 118 and one or more transistors 104 that are electrically connected to the BSPDN 118. For example, the BSPDN 118 may include one or more power rails 160 (e.g., power lines) that are coupled to the transistor(s) 104. Because they are part of the BSPDN 118, the power rails 160 may also be referred to herein as "backside" (i.e., BS) power rails, each of which may be provided by a respective conductive (e.g., metal) line on the BS of the IC 110.

A transistor 104 may overlap a BS power rail 160 in a vertical direction Z. The BS power rail 160 may extend longitudinally (i.e., longest) in a horizontal direction Y, and may be electrically connected to the transistor 104. In some embodiments, the horizontal direction Y may be perpendicular to the vertical direction Z and perpendicular to another horizontal direction X.

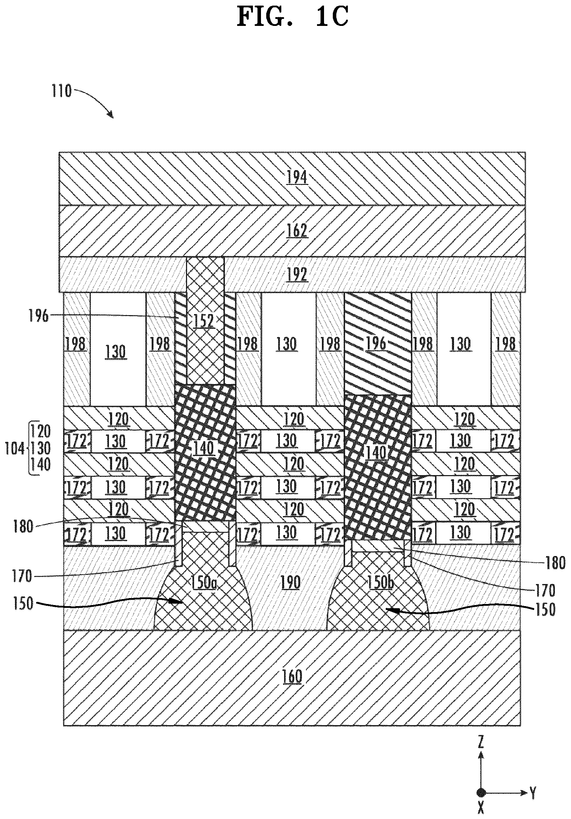

FIG. 1C is an example cross-sectional view of the IC 110. As shown in FIG. 1C, one or more BS contacts 150a, 150b (collectively, 150) may couple a BS power rail 160 of the BSPDN 118 (FIG. 1B) to a transistor 104. For example, the IC 110 may include two BS contacts 150a, 150b that couple the BS power rail 160 to respective S/D regions 140 of the transistor 104. The BS contacts 150a, 150b may be conductive (e.g., metal) contacts that each have a lower surface that is on (e.g., that contacts) an upper surface of the BS power rail 160. As an example, the BS contacts 150a, 150b may comprise cobalt (Co), ruthenium (Ru), molybdenum (Mo), tungsten (W), or another metal. According to some embodiments, the BS contacts 150a, 150b may be DBCs that are part of the BSPDN 118.

Each of the BS contacts 150a, 150b may be coupled between an overlying S/D region 140 and the BS power rail 160. In some embodiments, each of the BS contacts 150a, 150b may be coupled to its overlying S/D region 140 by a semiconductor buffer (e.g., blocking) layer 180. Accordingly, the semiconductor buffer layer 180 may be between, in the vertical direction Z, each BS contact 150 and its overlying S/D region 140. For example, an upper surface of the semiconductor buffer layer 180 may contact a lower surface of the S/D region 140 and a lower surface of the semiconductor buffer layer 180 may contact an upper surface of the BS contact 150. The semiconductor buffer layer 180 may comprise, for example, silicon. According to some embodiments, the semiconductor buffer layer 180 may be free of germanium.

A dielectric material 170 may be on sidewalls of upper portions of the BS contacts 150a, 150b. The dielectric material 170 may comprise a relatively thin layer that electrically isolates the BS contacts 150a, 150b from a gate 130 of the transistor 104. The dielectric material 170 may thus serve as an insulating sidewall spacer that inhibits/prevents an electrical short between the gate 130 and the BS contacts 150a, 150b, and the dielectric material 170 may therefore also be referred to herein as a "dielectric spacer" or a "sidewall spacer." In some embodiments, the semiconductor buffer layer 180 may be between, in the horizontal direction Y, a pair of the sidewall spacers. The sidewall spacers may thus protrude upward in the vertical direction Z beyond the upper surfaces of the BS contacts 150a, 150b. Moreover, the sidewall spacers may protrude upward in the vertical direction Z beyond an upper surface of a BS isolation region 190, and thus may overlap the gate 130 in the horizontal direction Y.

For ease of differentiating between the two different BS contacts 150 shown in FIG. 1C, one of the BS contacts 150 is labeled 150a, which may be referred to herein as a "first" BS contact, and another is labeled 150b, which may be referred to herein as a "second" BS contact. The first BS contact 150a may be thicker than the second BS contact 150b in the vertical direction Z. As an example, the upper portion of the first BS contact 150a may be vertically thicker than the upper portion of the second BS contact 150b. The upper surface of the first BS contact 150a may thus be at a higher level, in the vertical direction Z, than the upper surface of the second BS contact 150b. For example, the BS isolation region 190 may be on side surfaces of the BS contacts 150a, 150b, and the upper portion of the first BS contact 150a may protrude upward in the vertical direction Z beyond the upper surface of the BS isolation region 190, whereas the upper surface of the second BS contact 150b may be at level that is below that of the upper surface of the BS isolation region 190. According to some embodiments, the lower surface of the first BS contact 150a may be coplanar with the lower surface of the second BS contact 150b.

The gate 130 may be on a stack of channel layers 120 of the transistor 104. The channel layers 120, the gate 130, and the S/D regions 140 are each part of the transistor 104. Sidewalls of the channel layers 120 may contact, and be electrically connected to, the S/D regions 140. As shown in FIG. 1C, the semiconductor buffer layer 180 may be thinner, in the vertical direction Z, than each of the channel layers 120. The gate 130 is a conductive gate that may be between (in the vertical direction Z) the channel layers 120, and may be spaced apart from the S/D regions 140 in the horizontal direction Y by insulating spacers 172. The gate 130 may include a metal or a semiconductor material. As an example, the gate 130 may include aluminum (Al), W, or another metal.

The insulating spacers 172 may be on sidewalls of the gate 130 and between, in the vertical direction Z, the channel layers 120. In some embodiments, upper ones of the insulating spacers 172 may contact the S/D regions 140 and sidewalls of the gate 130, and lower (e.g., lowest) ones of the insulating spacers 172 may contact sidewalls of the dielectric material 170 and sidewalls of the gate 130. According to some embodiments, the insulating spacers 172 may comprise, for example, nitrogen (e.g., silicon nitride). The insulating spacers 172 may also be referred to herein as "inner spacers," as they may be situated between nanosheet/nanowire channels within a transistor.

An FS contact 152 may be on (e.g., in contact with) an upper surface of the S/D region 140 that overlies the first BS contact 150a. The FS contact 152 may therefore overlap the first BS contact 150a in the vertical direction Z. The FS contact 152 is a conductive (e.g., metal) contact that may be electrically isolated from the gate 130 by an isolation region 198. According to some embodiments, a first portion of another isolation region 196 may be between, in the horizontal direction Y, sidewalls of the FS contact 152 and sidewalls of the isolation region 198. A second portion of the isolation region 196 may be on an upper surface of the S/D region 140 that overlies the second BS contact 150b. The isolation region 196 may comprise, for example, an oxide. In some embodiments, an insulating material of the isolation region 196 may be different from that of the isolation region 198.

An FS isolation region 192 may be on an upper surface of the gate 130, an upper surface of the isolation region 196, and an upper surface of the isolation region 198. According to some embodiments, the FS isolation region 192 may comprise a different insulating material from that of the isolation region 196 and/or the isolation region 198. Moreover, the FS isolation region 192 may comprise the same insulating material as that of the BS isolation region 190. As an example, the BS isolation region 190 and the FS isolation region 192 may each comprise an oxide.

An upper portion of the FS contact 152 may be in the FS isolation region 192 and may be electrically connected to (e.g., in contact with a lower surface of) an overlying FS conductive layer 162. In some embodiments, the FS conductive layer 162 may comprise the same conductive material (e.g., the same metal) as that of the BS power rail 160. Moreover, the FS conductive layer 162 may be formed by a BEOL operation/process, which may provide multi-layered interconnections, such as wirings and vias. According to some embodiments, the BS power rail 160 may be thicker, in the vertical direction Z, than the FS conductive layer 162.

A wafer 194 may be on an upper surface of the FS conductive layer 162. The FS conductive layer 162 may thus be between, in the vertical direction Z, the wafer 194 and the FS contact 152. The wafer 194 may comprise, for example, a carrier wafer/substrate.

For simplicity of illustration, a gate insulation layer is omitted from the view in FIG. 1C. It will be understood, however, that a gate insulation layer may extend between each of the channel layers 120 and the gate 130. The gate insulation layers may wrap around the channel layers 120 and may be thinner than the insulating spacers 172.

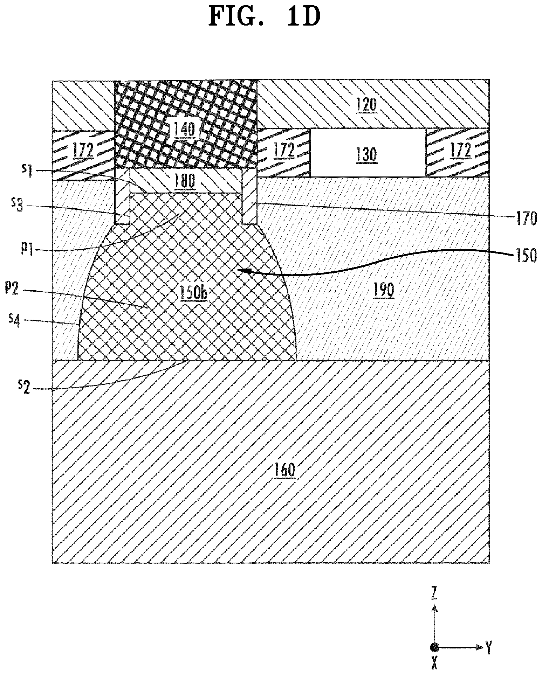

FIG. 1D is an enlarged view of a portion of FIG. 1C that includes the second BS contact 150b. As shown in FIG. 1D, the second BS contact 150b has an upper surface s₁ and a lower surface s₂ that is wider, in the horizontal direction Y, than the upper surface s₁. The upper surface s₁ and the lower surface s₂ may be an uppermost surface and a lowermost surface, respectively, of the second BS contact 150b. In some embodiments, the semiconductor buffer layer 180 is in contact with both the lower surface of the S/D region 140 and the upper surface s₁. The lower surface s₂ is wider, in the horizontal direction Y, than the S/D region 140, and the upper surface s₁ is not wider (and instead is narrower), in the horizontal direction Y, than the S/D region 140. According to some embodiments, the second BS contact 150b may be aligned with the S/D region 140 such that the lower surface of the S/D region 140 overlaps an entirety of the upper surface s₁ in the vertical direction Z. For example, the upper surface s₁ may be aligned with (and in contact with) an entirety of the lower surface of the semiconductor buffer layer 180, which may be between outer sidewalls of the dielectric material 170 that may be aligned with (e.g., coplanar with in the vertical direction Z) opposite sidewalls of the S/D region 140.

FIG. 1D also shows that the second BS contact 150b includes an upper portion p₁ and a lower portion p₂ that is wider, in the horizontal direction Y, than the upper portion p₁. The upper portion p₁ includes the upper surface s₁, and the lower portion p₂ includes the lower surface s₂. According to some embodiments, the upper portion p₁ may have a constant (i.e., uniform) width in the horizontal direction Y along the vertical direction Z. The lower portion p₂, however, may have a variable width in the horizontal direction Y that narrows as the lower portion p₂ approaches (i.e., is closer to) the upper portion p₁. The lower surface s₂ may thus be the widest part of the lower portion p₂. In some embodiments, the width of the lower portion p₂ may monotonically narrow from the lower surface s₂ to the upper portion p₁, and thus may only widen as the lower portion p₂ approaches the BS power rail 160.

The upper portion p₁ may have a vertical sidewall (i.e., a vertical side surface) s₃ that is overlapped by the S/D region 140 in the vertical direction Z. The vertical sidewall s₃ may be parallel to the vertical direction Z. The lower portion p₂, on the other hand, may have a curved side surface s₄ having at least a portion that is not parallel to the vertical direction Z. The curved side surface s₄ may extend from the lower surface s₂ to the vertical sidewall s₃ (or to the dielectric material 170). According to some embodiments, the curved side surface s₄ may be a convex side surface. As a result, the lower portion p₂ may non-linearly increase in width as the lower portion p₂ approaches the BS power rail 160 (and thus moves farther away from the S/D region 140 and the channel layers 120). In other embodiments, the second BS contact 150b may have a trapezoidal shape, and the side surface s₄ may thus be a linear (rather than curved) surface.

The BS isolation region 190 may be on the vertical sidewall s₃ and the curved side surface s₄. As an example, the BS isolation region 190 may contact the curved side surface s₄. The dielectric material 170 may be between, in the horizontal direction Y, the BS isolation region 190 and the vertical sidewall s₃. A first, inner sidewall of the dielectric material 170 may contact the vertical sidewall s₃, and a second, outer sidewall of the dielectric material 170 may contact the BS isolation region 190. In some embodiments, the dielectric material 170 may protrude upward in the vertical direction Z beyond a level of an upper surface of the BS isolation region 190. The dielectric material 170 may therefore overlap the semiconductor buffer layer 180 and/or the gate 130 in the horizontal direction Y. The semiconductor buffer layer 180 may be on (e.g., may contact) a sidewall of the dielectric material 170. Moreover, the BS isolation region 190 may comprise a different insulating material from that of the dielectric material 170. As an example, the BS isolation region 190 may comprise an oxide, and the dielectric material 170 may comprise silicon nitride.

The channel layers 120 may overlap the lower portion p₂ in the vertical direction Z (which may be perpendicular to the lower surface s₂). For example, the channel layers 120 may overlap the curved side surface s₄ and the lower surface s₂ in the vertical direction Z. In contrast, FIG. 1D shows that the channel layers 120 do not overlap the upper portion p₁ in the vertical direction Z, as the upper portion p₁ is narrower than the overlying S/D region 140 that is horizontally adjacent (and electrically connected to) the channel layers 120.

For simplicity of illustration, the upper portion p₁, the lower portion p₂, and the surfaces s₁-s₄ are labelled in FIG. 1D for the second BS contact 150b and not for the first BS contact 150a (FIG. 1C). It will be understood, however, that the first BS contact 150a may also have the upper portion p₁, the lower portion p₂, and the surfaces s₁-s₄, with a primary difference being that the upper surface s₁ of the second BS contact 150b may be lower than that of the first BS contact 150a.

Though conventional semiconductor devices may have a BDI layer on an upper sidewall of a BS contact, the semiconductor device 100 (FIG. 1A) according to embodiments herein may be free of a BDI layer on the vertical sidewall s₃. As a result, no BDI layer may contact both the vertical sidewall s₃ and a lower surface of the gate 130. The absence of a BDI layer in the structure shown in FIG. 1D may allow this structure to be used in IC devices having a relatively narrow CPP. Such a non-BDI scheme may be necessary due to, for example, hard-mask loss during silicon reactive-ion etching (RIE).

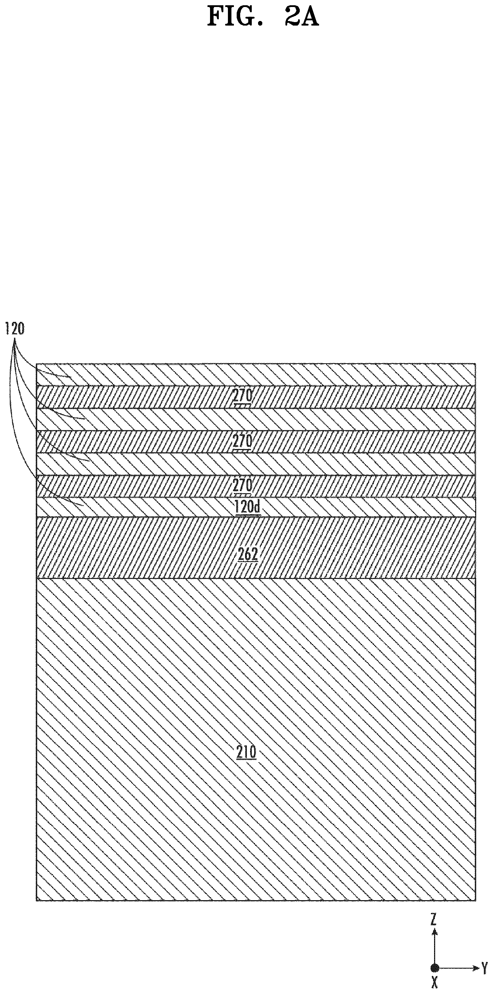

Forming a conventional BS contact using a non-BDI scheme may result in void formation in the BS contact, due to a high aspect ratio (e.g., a narrow cavity in which the BS contact is formed), and/or may result in a smaller vertical margin for a sacrificial (i.e., placeholder) contact that will be replaced by the BS contact. The term "vertical margin" as used herein, may refer to a vertical thickness of an upper (e.g., constant-width) portion of the sacrificial contact. This vertical margin may be the same as (or similar to) a vertical distance between a lower surface of a lowermost channel layer and an upper surface of a semiconductor (e.g., silicon or silicon germanium) layer that underlies the lowermost channel layer. As described in further detail with respect to FIGs. 2A-2Q, however, operations of forming the structure shown in FIG. 1C according to embodiments herein may use a non-BDI scheme that provides a vertical margin similar to what would be provided using a BDI scheme.

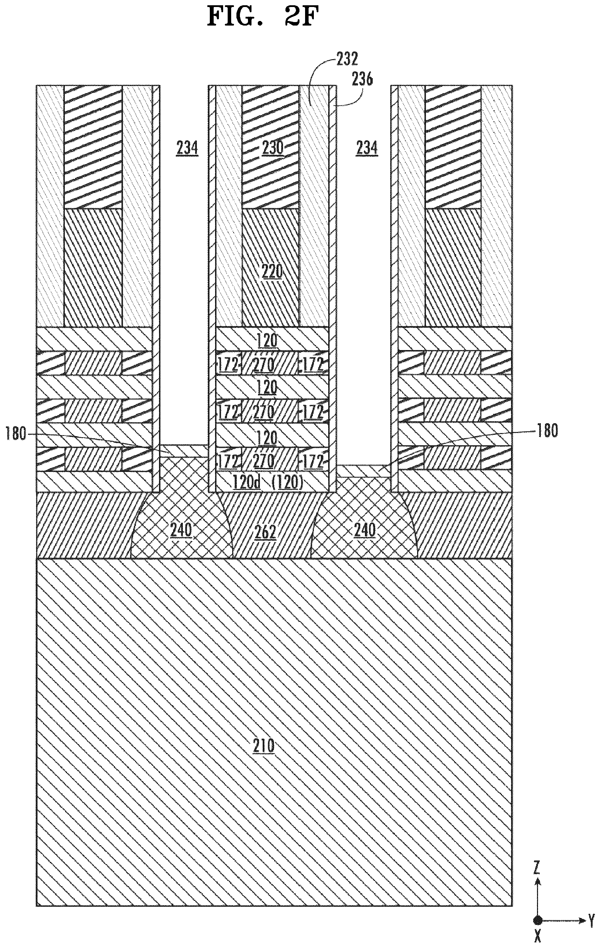

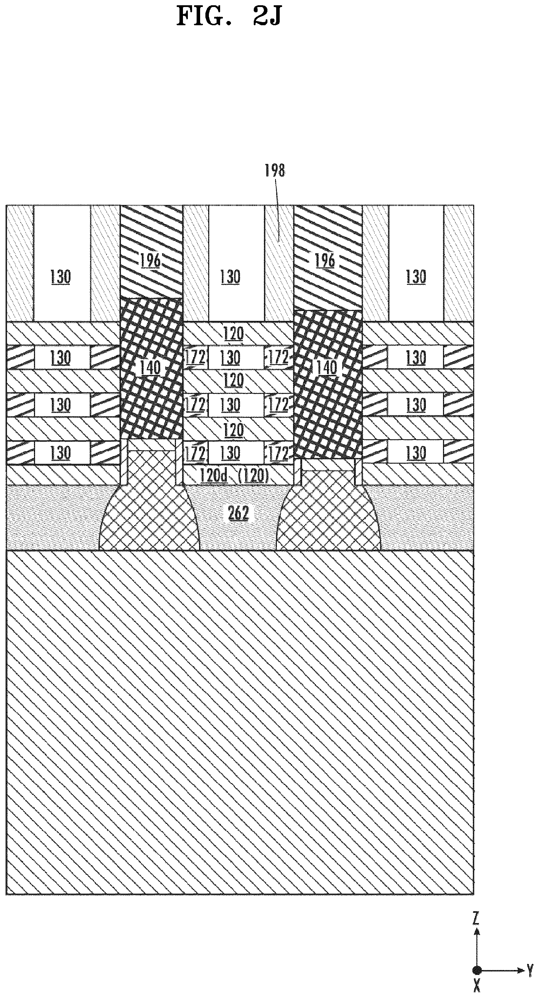

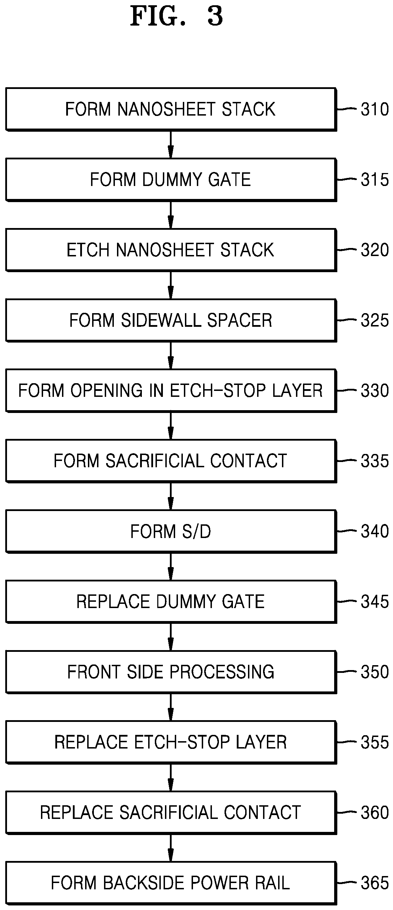

FIGs. 2A-2Q are cross-sectional views illustrating operations of forming the structure shown in FIG. 1C. FIG. 3 is a flowchart corresponding to the operations shown in FIGs. 2A-2Q. These operations use a non-BDI scheme that provides good (e.g., void-free) conductive-material fill for BS contacts 150a, 150b (FIG. 1C) and a relatively thick vertical margin for upper portions of sacrificial contacts 240 (FIG. 2F). This vertical margin may be the same as (or similar to) a distance in the vertical direction Z between a lower surface of a non-dummy lowermost channel layer 120 (FIG. 2J) and an upper surface of a sacrificial etch-stop layer 262 (FIG. 2A). The good conductive-material fill can be facilitated by using the sacrificial etch-stop layer 262 to help form the BS contacts 150a, 150b to each have a relatively wide lower portion p₂ (FIG. 1D), which may have a curved (e.g., convex) side surface s₄ (FIG. 1D), and by using a dummy channel layer 120d (FIG. 2A) between the sacrificial etch-stop layer 262 and the non-dummy channel layers 120. The relatively thick vertical margin can facilitate relatively thick upper portions p₁ (FIG. 1D) of the BS contacts 150a, 150b, where the relatively thick upper portions p₁ may be similar to what would be provided using a BDI scheme.

As shown in FIGs. 2A and 3, the operations of forming the structure shown in FIG. 1C may include forming (Block 310) a stack of semiconductor channel layers 120 on a substrate 210. In some embodiments, the channel layers 120 may be nanosheets, and the stack may thus be a nanosheet stack. Sacrificial gate layers 270 may be alternately stacked on the substrate 210 with the channel layers 120. Moreover, the sacrificial etch-stop layer 262 may be between the substrate 210 and a lowermost one of the channel layers 120. The sacrificial etch-stop layer 262 may also be referred to herein as a sacrificial layer or an etch-stop layer.

The lowermost one of the channel layers 120 (i.e., the closest channel layer 120 to the substrate 210) may serve as a dummy channel layer 120d that will not be an active layer in the structure shown in FIG. 1C, but rather may be removed before completing the structure shown in FIG. 1C. The lowermost one of the channel layers 120 may help to provide a relatively thick vertical margin for upper portions of sacrificial contacts 240 (FIG. 2F) that will subsequently be formed. This vertical margin may be equal (or similar) to a distance in the vertical direction Z between the lower surface of the non-dummy lowermost channel layer 120 (i.e., the second-closest channel layer 120 to the substrate 210) and the upper surface of the sacrificial etch-stop layer 262.

The channel layers 120 form part of the transistor 104 that is shown in FIG. 1C. The channel layers 120 are semiconductor layers that comprise, for example, silicon (e.g., polysilicon). In a subsequent process/operation, the sacrificial gate layers 270 may be replaced with conductive gates 130 (FIG. 1C). Moreover, the sacrificial etch-stop layer 262 and the lowermost one of the channel layers 120 (i.e., dummy channel layer 120d) may be replaced with a BS isolation region 190 (FIG. 1C) in a subsequent process/operation.

The sacrificial gate layers 270 may comprise, for example, silicon germanium. Accordingly, the sacrificial gate layers 270 may have an etch selectivity relative to the channel layers 120. The sacrificial gate layers 270 may also have an etch selectivity relative to the sacrificial etch-stop layer 262. For example, the sacrificial etch-stop layer 262 and the sacrificial gate layers 270 may each comprise silicon germanium, but with different concentrations of germanium. As an example, the sacrificial etch-stop layer 262 may have a higher concentration of germanium (e.g., 55 at%) than the sacrificial gate layers 270 (e.g., 25 at%).

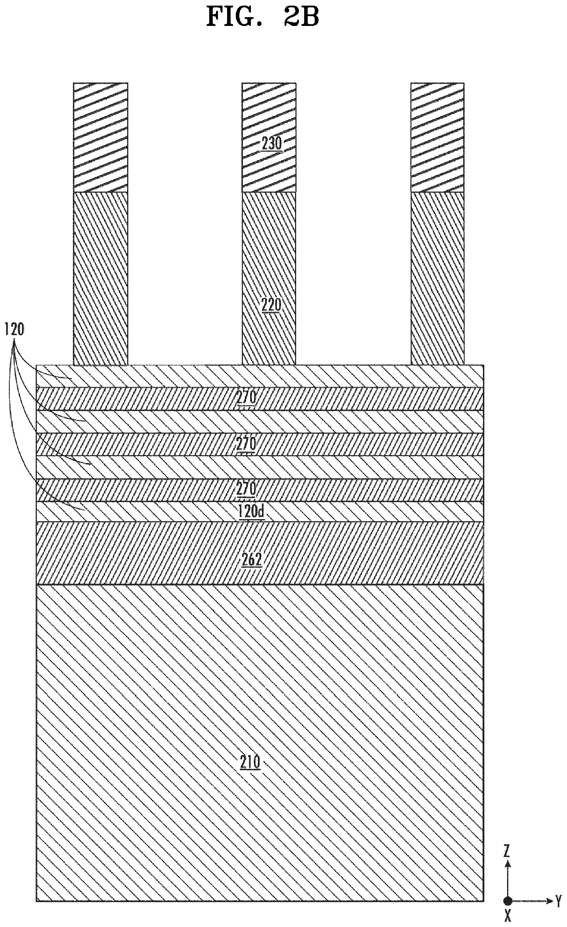

As shown in FIGs. 2B and 3, a dummy gate 220 may be formed (Block 315) on the stack. For example, a material of the dummy gate 220 may be formed (e.g., epitaxially grown or deposited) on the stack and then may be etched to provide segments of the dummy gate 220 that are spaced apart from each other in the horizontal direction Y. Moreover, an insulating material 230 (e.g., a shallow trench isolation region) may be formed on an upper surface of the dummy gate 220.

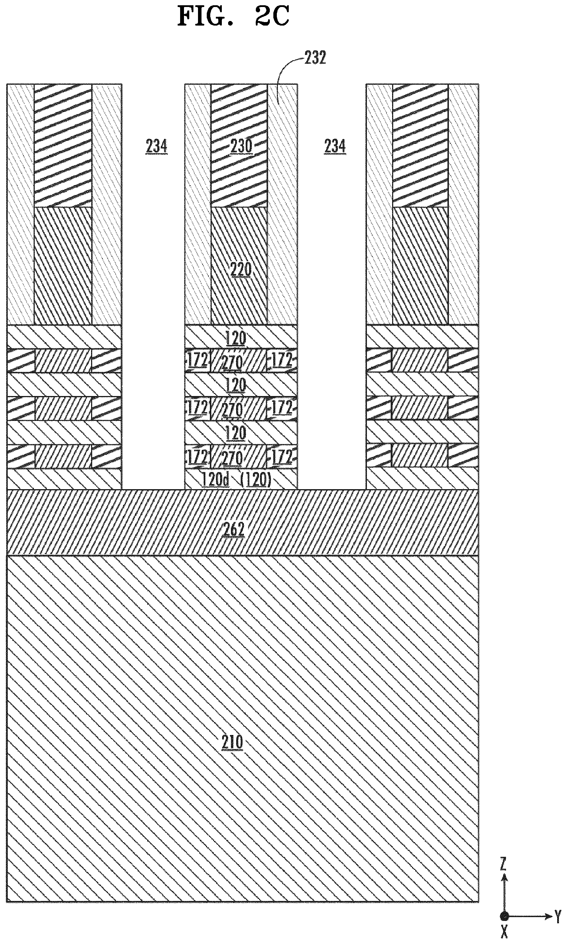

As shown in FIGs. 2C and 3, insulating spacers 232 may be formed on sidewalls of the dummy gate 220 and the insulating material 230, and the nanosheet stack may be etched (Block 320) while using the sacrificial etch-stop layer 262 as a recess/etch stop. As a result, openings 234 may be formed that expose an upper surface of the sacrificial etch-stop layer 262. According to some embodiments, the insulating material 230 and the insulating spacers 232 may protect underlying portions of the stack during the etch of the stack. The openings 234 may divide the stack shown in FIG. 2B into three stacks. Moreover, insulating spacers 172 may be formed on sidewalls of the sacrificial gate layers 270 through the openings 234.

In some embodiments, the insulating spacers 172 may be formed on sidewalls of the sacrificial gate layers 270 and between, in the vertical direction Z, the channel layers 120. For example, the sacrificial gate layers 270 may be etched (e.g., indented/narrowed in the horizontal direction Y) to form openings in the sacrificial gate layers 270 between the channel layers 120. Sidewalls of the sacrificial gate layers 270 may be exposed through the openings, and the insulating spacers 172 may be formed in the openings. According to some embodiments, an insulating material of the insulating spacers 172 may be different from the insulating material 230 and/or different from an insulating material of the insulating spacers 232. As an example, the insulating spacers 172 may comprise silicon nitride (e.g., Si₃N₄).

The sacrificial etch-stop layer 262 may, in some embodiments, be thicker (in the vertical direction Z) than any layer between the sacrificial etch-stop layer 262 and a farthest one (i.e., highest one) of the channel layers 120 from the sacrificial etch-stop layer 262. The sacrificial etch-stop layer 262 may therefore be thicker than any of the sacrificial gate layers 270, as well as thicker than any of the channel layers 120.

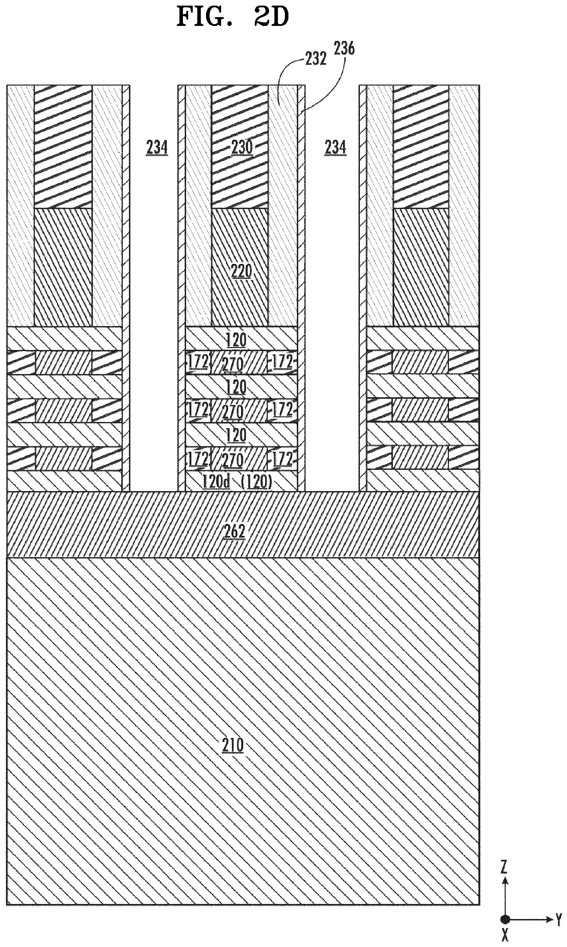

As shown in FIGs. 2D and 3, a sidewall spacer 236 may be formed (Block 325) in the openings 234. The sidewall spacer 236 may comprise an insulating material and may be on sidewalls of the channel layers 120 and sidewalls of the insulating spacers 172, 232. In some embodiments, the sidewall spacer 236 may be formed by an insulating layer deposition process/operation in the openings 234. For example, the sidewall spacer 236 may comprise silicon nitride (e.g., Si₃N₄) and may be formed by a deposition process/operation that provides a thin insulating liner in the openings 234. The sidewall spacer 236 may protect the channel layers 120 and the insulating spacers 172, 232 during an etch of the sacrificial etch-stop layer 262 that is performed in a subsequent process/operation.

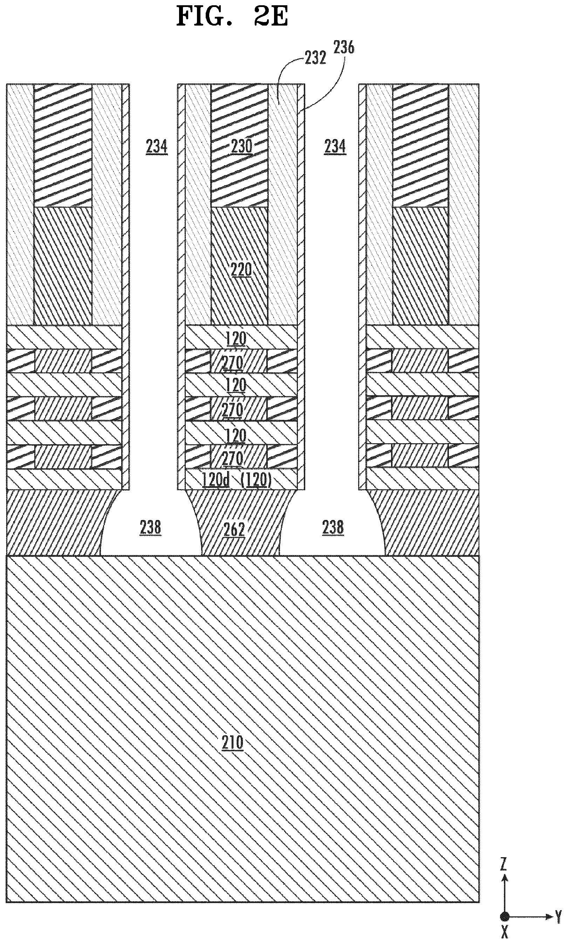

As shown in FIGs. 2E and 3, openings 238 may be formed (Block 330) in the sacrificial etch-stop layer 262. The openings 238, which may expose an upper surface of the substrate 210, may be formed by, for example, a dry etch and/or a wet etch process/operation performed through the openings 234. In some embodiments, the dry etch and/or wet etch (which may be isotropic) may form the openings 238 to have shapes that increase in width (in the horizontal direction Y) as the openings 238 approach the substrate 210. For example, the openings 238 may be wider than the overlying openings 234, and may monotonically increase in width as the openings 238 are farther from the openings 234. The openings 238 thus narrow in width as the sacrificial etch-stop layer 262 approaches a lowermost one of the channel layers 120 (which serves as a dummy channel layer 120d).

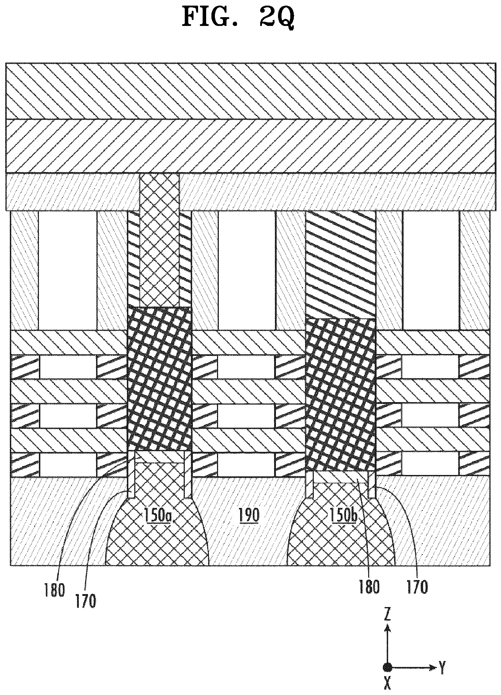

Accordingly, embodiments herein may use the sacrificial etch-stop layer 262 to define shapes of the openings 238, which will subsequently be occupied by sacrificial contacts 240 (FIG. 2F) and then BS contacts 150 (FIG. 2Q). As an example, an opening 238 may define the shape of the lower portion p₂ (FIG. 1D) of the BS contact 150 that will replace the sacrificial contact 240 that will be formed in that opening 238. Moreover, the upper surface of the sacrificial etch-stop layer 262 may define a level in the vertical direction Z at which the BS contact 150 will transition from the lower portion p₂ (which has a variable width in the horizontal direction Y) to the upper portion p₁ (which may have a constant width) (FIG. 1D).

As shown in FIGs. 2F and 3, sacrificial (i.e., placeholder) contacts 240 may be formed (Block 335) in the openings 238 (FIG. 2E). In some embodiments, the sacrificial contacts 240 may be epitaxially grown from the sacrificial etch-stop layer 262. For example, the sacrificial contacts 240 may comprise silicon germanium that has a different (e.g., higher) germanium concentration from that of the sacrificial etch-stop layer 262. The sacrificial contacts 240 may thus have an etch selectivity relative to the sacrificial etch-stop layer 262.

According to some embodiments, upper portions of the sacrificial contacts 240 may protrude upward (in the vertical direction Z) into the openings 234. The sacrificial contacts 240 may thus be between opposite portions of the sidewall spacer 236. Moreover, one of the sacrificial contacts 240 may have a higher upper surface than the other one of the sacrificial contacts 240, as long as semiconductor buffer layers 180 on the sacrificial contacts 240 do not overlap any channel layers 120 in the horizontal direction Y (as such overlap could result in an electrical short). Such a height difference between the sacrificial contacts 240 can occur due to, for example, manufacturing process deviations. The sacrificial contacts 240, however, are not required to have different heights. The upper surfaces of the sacrificial contacts 240 may thus be coplanar in some embodiments.

In some embodiments, a semiconductor buffer (e.g., blocking) layer 180 may be formed on the upper surface of each sacrificial contact 240. As an example, the semiconductor buffer layer 180 may be a relatively thin silicon layer that is epitaxially grown from each sacrificial contact 240. For example, the semiconductor buffer layer 180 may be thinner, in the vertical direction Z, than each of the channel layers 120. An upper surface of the semiconductor buffer layer 180 may be coplanar with, or at a lower level (in the vertical direction Z) than, an upper surface of a lowermost one of the sacrificial gate layers 270. According to some embodiments, the semiconductor buffer layer 180 may be free of germanium.

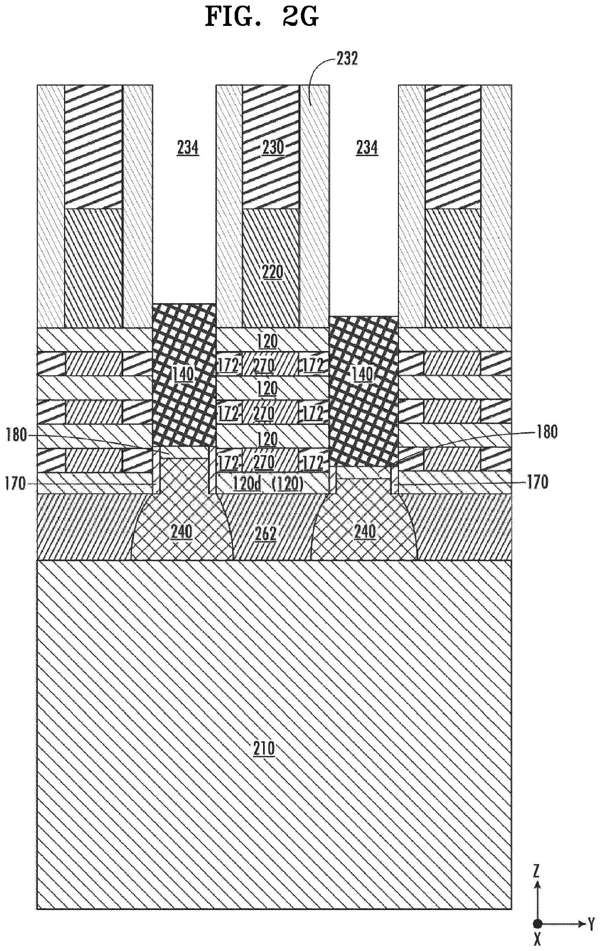

As shown in FIGs. 2G and 3, portions of the sidewall spacer 236 (FIG. 2F) that are exposed after forming the sacrificial contacts 240 and the semiconductor buffer layer 180 may be removed, and S/D regions 140 may be formed (Block 340) in the openings 234, on the sacrificial contacts 240 and the semiconductor buffer layer 180. As a result, the sidewall spacer 236 may be removed from sidewalls of all of the channel layers 120 except for the lowermost one of the channel layers 120 (which serves as a dummy channel layer 120d). Portions of the sidewall spacer 236 that remain provide a dielectric material 170 that is on sidewalls of upper portions of the sacrificial contacts 240 and on sidewalls of the semiconductor buffer layer 180. According to some embodiments, the S/D regions 140 may be wider, in the horizontal direction Y, than the semiconductor buffer layer 180, and thus may overlap the dielectric material 170 in the vertical direction Z.

In some embodiments, the S/D regions 140 may be formed by epitaxial growth. For example, the S/D regions 140 may be epitaxially grown from the channel layers 120 (except for the dummy channel layer 120d). According to some embodiments, the channel layers 120 may comprise silicon, and the S/D regions 140 may comprise silicon, silicon carbide, or silicon germanium.

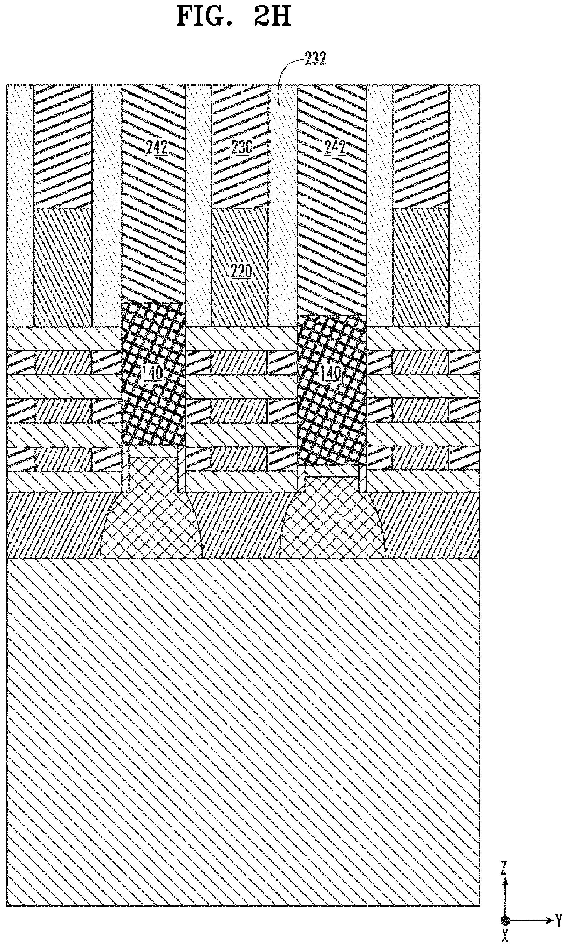

As shown in FIG. 2H, an isolation region 242 may be formed in the openings 234 (FIG. 2G), on the S/D regions 140. As an example, the isolation region 242 may be formed by filling the openings 234 with an oxide material and then performing a planarization operation/process (e.g., chemical-mechanical planarization (CMP)).

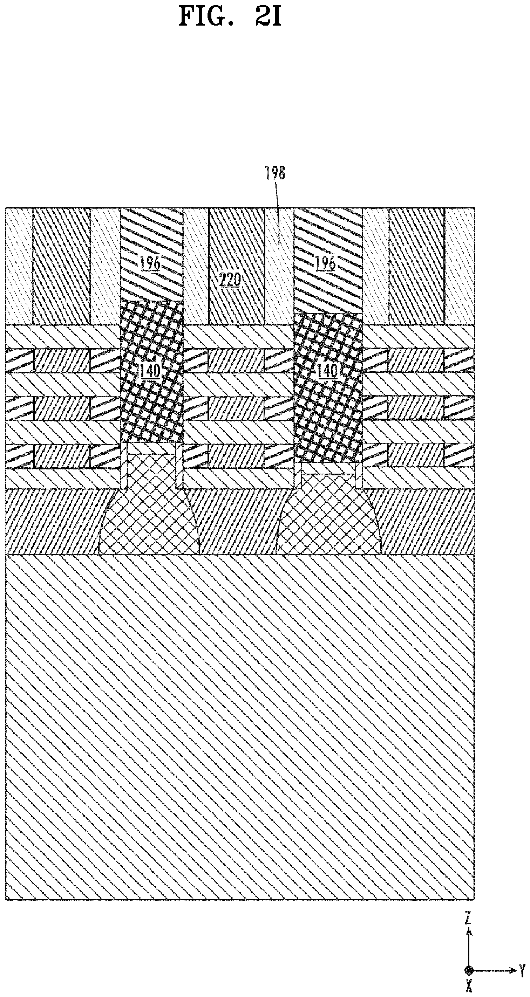

As shown in FIG. 2I, the insulating material 230 (FIG. 2H) may be removed, and the isolation region 242 (FIG. 2H) and the insulating spacers 232 (FIG. 2H) may be vertically thinned, by performing a further planarization operation/process. For example, a silicon-nitride CMP may be performed. After the CMP, upper surfaces of the dummy gate 220 may be exposed. Moreover, the vertically-thinned isolation region 242 provides an isolation region 196, and the vertically-thinned insulating spacers 232 provide another isolation region 198 that is between, in the horizontal direction Y, the dummy gate 220 and the isolation region 196. In some embodiments, the isolation regions 196, 198 may have upper surfaces that are coplanar with an upper surface of the dummy gate 220.

As shown in FIGs. 2J and 3, the dummy gate 220 (FIG. 2I) and the sacrificial gate layers 270 (FIG. 2G) may be replaced (Block 345) with a conductive gate 130. For example, the conductive gate 130 may comprise a high-k metal gate or another type of conductive gate. Though omitted from view in the drawings for simplicity of illustration, gate insulation layers may, according to some embodiments, be formed between the conductive gate 130 and the channel layers 120. The lowermost one of the channel layers 120 is a dummy channel layer 120d that does not overlap the S/D regions 140 in the horizontal direction Y.

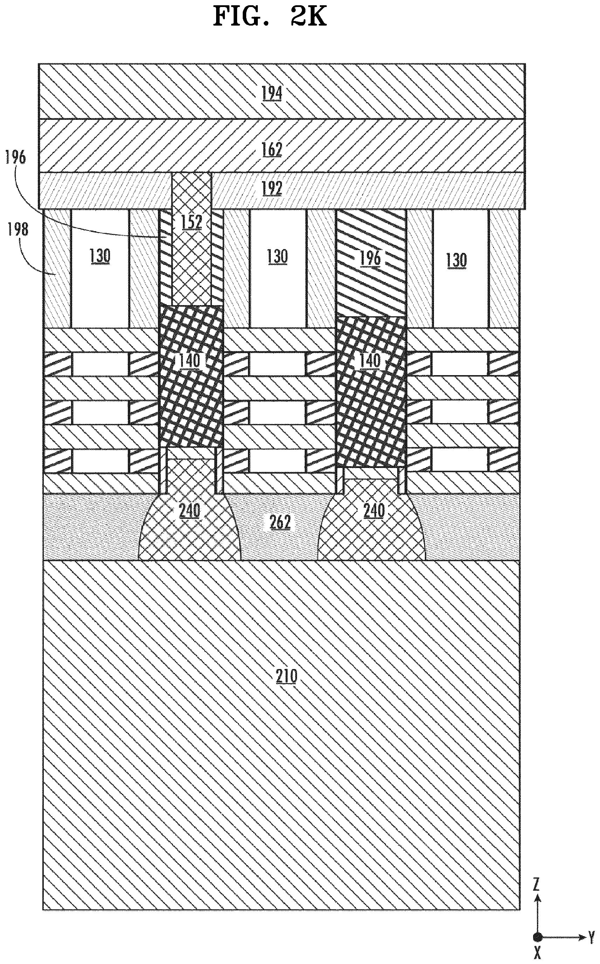

As shown in FIGs. 2K and 3, FS processing may be performed (Block 350). The FS processing may include forming an FS isolation region 192 on the gate 130 and the isolation regions 196, 198. Moreover, the FS processing may include forming an FS contact 152 on an upper surface of one of the S/D regions 140. An upper portion of the FS contact 152 may be in an opening in the FS isolation region 192, and may be in contact with a lower surface of an FS conductive layer 162 that is formed on an upper surface of the FS isolation region 192. The FS conductive layer 162 may be formed by, for example, a BEOL operation/process.

In some embodiments, wafer bonding (e.g., carrier wafer bonding) may be performed on the FS of the structure after forming the FS contact 152. As an example, a wafer (e.g., a substrate) 194 may be bonded to the FS conductive layer 162. The wafer 194 may thus be referred to herein as an "FS" wafer/substrate, and the substrate 210 may be referred to herein as a "BS" substrate 210.

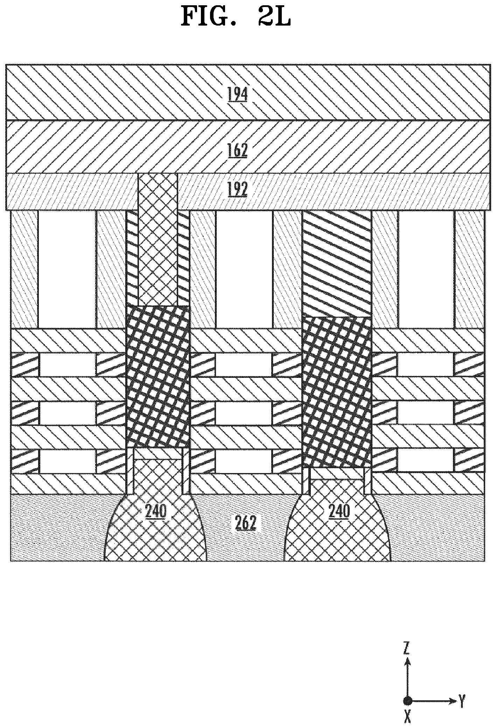

As shown in FIG. 2L, the BS substrate 210 (FIG. 2K) may be removed after bonding the FS wafer 194. Removal of the BS substrate 210 can expose a lower surface of the sacrificial etch-stop layer 262 and lower surfaces of the sacrificial contacts 240. According to some embodiments, the lower surface of the sacrificial etch-stop layer 262 may be coplanar with the lower surfaces of the sacrificial contacts 240.

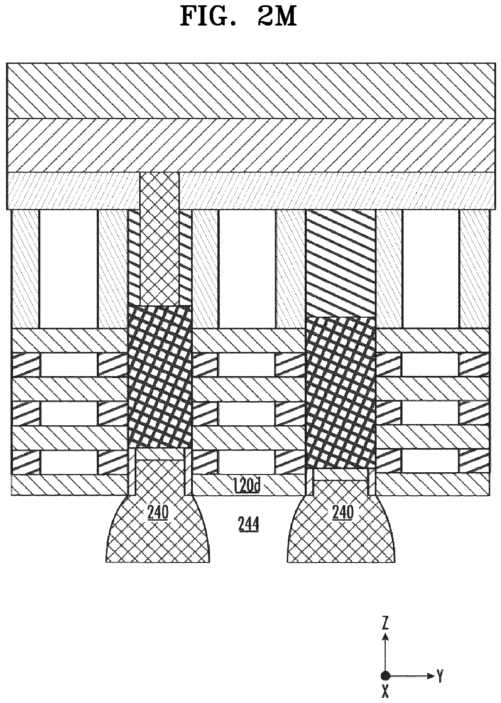

As shown in FIG. 2M, the sacrificial etch-stop layer 262 (FIG. 2L) may be removed, thereby forming an opening 244 that exposes side surfaces of lower portions of the sacrificial contacts 240 and a lower surface of the dummy channel layer 120d. Due to an etch selectivity between the sacrificial etch-stop layer 262 and the sacrificial contacts 240, the sacrificial etch-stop layer 262 can be removed without damaging the sacrificial contacts 240. This etch selectivity may result from, for example, a germanium concentration in the sacrificial etch-stop layer 262 that is different from a germanium concentration in the sacrificial contacts 240.

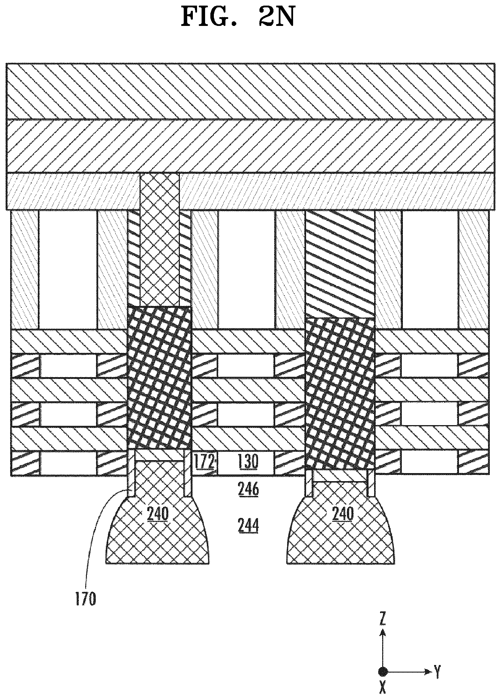

As shown in FIG. 2N, the dummy channel layer 120d (FIG. 2M) may be removed. As a result, an opening 246 may be formed that exposes a lower portion of a sidewall of the dielectric material 170. The opening 246 may also expose a lower surface of the gate 130.

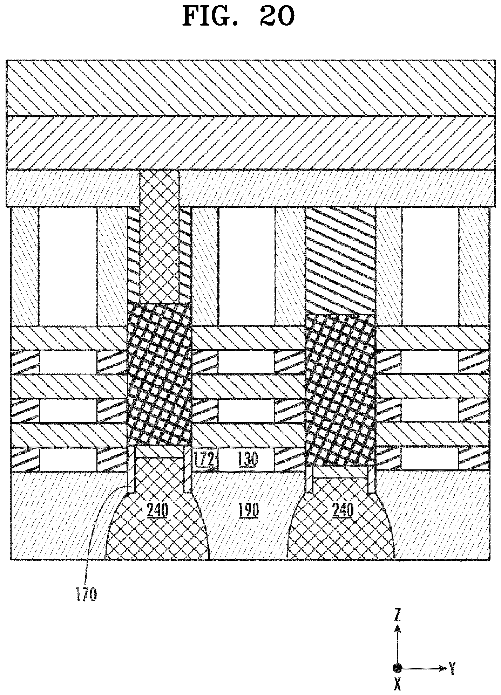

As shown in FIGs. 2O and 3, a BS isolation region 190 may be formed in the openings 244, 246 (FIG. 2N), thus replacing (Block 355) the sacrificial etch-stop layer 262 (FIG. 2L) and the dummy channel layer 120d (FIG. 2M). In some embodiments, the BS isolation region 190 may contact a side surface of a lower portion of each sacrificial contact 240. Moreover, the BS isolation region 190 may be on a lower surface of the gate 130 and may contact a side surface of the dielectric material 170. In some embodiments, the BS isolation region 190 may contact lower surfaces of lower ones of the insulating spacers 172.

The BS isolation region 190 may comprise an oxide (e.g., silicon oxide). According to some embodiments, the BS isolation region 190 may be formed by an oxide fill operation/process in the openings 244, 246. A material formed by the oxide fill operation/process may then be planarized (e.g., by CMP) to expose lower surfaces of the sacrificial contacts 240.

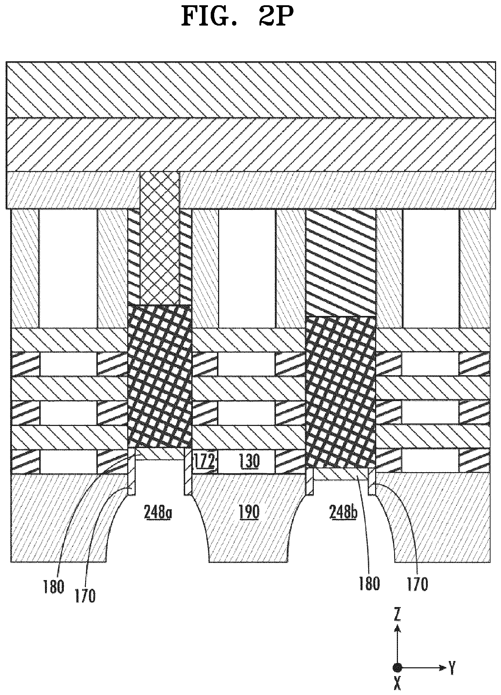

As shown in FIG. 2P, the sacrificial contacts 240 (FIG. 2O) may be removed, thereby forming openings 248a, 248b. The opening 248a may extend higher than the opening 248b in the vertical direction Z. For example, an upper portion of the opening 248a may overlap a lower portion of the gate 130 in the horizontal direction Y, whereas no portion of the opening 248b may overlap the gate 130 in the horizontal direction Y. The openings 248a, 248b may expose lower surfaces of the semiconductor buffer layer 180 and inner sidewalls of the dielectric material 170. The semiconductor buffer layer 180 may serve as an etch-stop layer during removal of the sacrificial contacts 240.

The sacrificial contacts 240 (and thus the openings 248a, 248b that are formed by removing the sacrificial contacts 240) may have various shapes as long as lower portions thereof are wider (in the horizontal direction Y) than upper portions thereof. The wider lower portions provide larger openings 248a, 248b that allow the sacrificial contacts 240 to be more easily replaced by BS contacts 150a, 150b (FIG. 2Q), which may have the same (or similar) shapes as those of the sacrificial contacts 240. In some embodiments, the sacrificial contacts 240 (and thus the BS contacts 150a, 150b) may each have a trapezoidal shape. For example, an isotropic feature of a wet etch that is used to form openings 238 (FIG. 2E) in which the sacrificial contacts 240 are formed may result in a trapezoidal shape if the wet etch is performed for a relatively short amount of time.

As shown in FIGs. 2Q and 3, BS contacts 150a, 150b may be formed in the openings 248a, 248b (FIG. 2P), respectively, thus replacing (Block 360) the sacrificial contacts 240 (FIG. 2O). The BS contacts 150a, 150b comprise a conductive material (e.g., a metal). In some embodiments, the BS contacts 150a, 150b may comprise the same conductive material (e.g., the same metal) as the FS contact 152 (FIG. 2K). Moreover, the BS contacts 150a, 150b may be formed by a BS contact (e.g., metal) fill operation/process in the openings 248a, 248b. A material formed by the BS contact fill operation/process may then be planarized (e.g., by CMP) to expose a lower surface of the BS isolation region 190. The BS contacts 150a, 150b may thus have lower surfaces that are coplanar with a lower surface of the BS isolation region 190.

As shown in FIGs. 1C and 3, a BS power rail 160 may be formed (Block 365) on the lower surfaces of the BS contacts 150a, 150b and the lower surface of the BS isolation region 190. The BS power rail 160 may therefore be electrically connected to (e.g., in contact with) the BS contacts 150a, 150b.

Semiconductor device 100 (FIG. 1A) according to some embodiments herein may provide various advantages. These advantages include forming BS contacts 150a, 150b (FIG. 1C), which may be DBCs, that are fully aligned with overlying S/D regions 140 (FIG. 1C) without using a BDI layer. The BS contacts 150a, 150b may have relatively wide lower portions p₂ (FIG. 1D), which can help to prevent voids in the BS contacts 150a, 150b. Moreover, a dielectric material 170 (FIG. 1C) on upper portions p₁ (FIG. 1D) of the BS contacts 150a, 150b can help to prevent electrical shorts between the BS contacts 150a, 150b and a nearby gate 130 (FIG. 1C). The BS contacts 150a, 150b can be used even when the semiconductor device 100 have a relatively narrow CPP. Furthermore, the BS contacts 150a, 150b can be formed by a relatively simple BS process, can improve voltage drop, and can help overcome/compensate for power rail dimension limitations.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. A semiconductor device comprising:
a source/drain, S/D, region (140);
a backside, BS, contact (150, 150a, 150b) that comprises an upper surface (s1) that is on a lower surface of the S/D region; and
a BS power rail (160) that is on a lower surface (s2) of the BS contact (150, 150a, 150b) and is electrically connected to the S/D region (140) by the BS contact (150, 150a, 150b),
wherein the lower surface (s2) of the BS contact (150, 150a, 150b) is wider than the upper surface (s1) of the BS contact (150, 150a, 150b) in a horizontal direction (Y).

2. The semiconductor device of Claim 1, further comprising a semiconductor buffer layer (180) that is between the S/D region (140) and the BS contact (150, 150a, 150b).

3. The semiconductor device of Claim 2, wherein the semiconductor buffer layer (180) comprises silicon and is in contact with both the upper surface (s1) of the BS contact (150, 150a, 150b) and the lower surface (s2) of the S/D region (140).

4. The semiconductor device of any one of Claims 1 to 3,
wherein the lower surface (s2) of the BS contact (150, 150a, 150b) is wider than the S/D region (140) in the horizontal direction (Y), and
wherein the upper surface (s1) of the BS contact (150, 150a, 150b) is not wider than the S/D region (140) in the horizontal direction (Y).

5. The semiconductor device of any one of Claims 1 to 4, wherein the BS contact (150, 150a, 150b) comprises:
an upper portion (p1) that has a constant width-in the horizontal direction (Y) along a vertical direction (Z); and
a lower portion (p2) that has a width that narrows in the horizontal direction (Y) as the lower portion (p2) approaches the upper portion (p1).

6. The semiconductor device of Claim 5, wherein the semiconductor device (110) is free of a bottom dielectric isolation layer on a sidewall (s3) of the upper portion (p1) of the BS contact (150, 150a, 150b).

7. The semiconductor device of Claim 5, further comprising an isolation region (190) that is on a sidewall (s3) of the upper portion (p1) of the BS contact (150, 150a, 150b) and a side surface (s4) of the lower portion (p2) of the BS contact.

8. The semiconductor device of Claim 7, further comprising a dielectric material (170) that is between the isolation region (190) and the sidewall (s3) of the upper portion (p1) of the BS contact (150, 150a, 150b).

9. The semiconductor device of Claim 8,
wherein the dielectric material (170) protrudes upward beyond a level of an upper surface of the isolation region (190), and
wherein the isolation region (190) and the dielectric material (170) comprise different insulating materials.

10. The semiconductor device of any one of Claims 5 to 9,
wherein the S/D region (140) is part of a transistor (104) that comprises a stack of channel layers (120) that are electrically connected to the S/D region (140),
wherein the channel layers (120) overlap the lower portion (p2) of the BS contact (150, 150a, 150b) in the vertical direction (Z) that is perpendicular to the lower surface (s2) of the BS contact (150, 150a, 150b), and
wherein the channel layers (120) do not overlap the upper portion (p1) of the BS contact (150, 150a, 150b) in the vertical direction (Z).

11. The semiconductor device of Claim 10, further comprising a semiconductor buffer layer (180) that is between the S/D region (140) and the BS contact,
wherein the semiconductor buffer layer (180) is thinner, in the vertical direction, than each of the channel layers.

12. The semiconductor device of any one of Claims 1 to 4, wherein a lower portion (p2) of the BS contact (150, 150a, 150b) comprises a convex side surface (s4).

13. The semiconductor device of any one of Claims 1 to 4, further comprising a dielectric material (170) that is on a sidewall (s3) of an upper portion (p1) of the BS contact (150, 150a, 150b).

14. The semiconductor device of Claim 13, wherein the dielectric material (170) comprises silicon nitride and is in contact with the sidewall (s3).

15. A method of forming a semiconductor device, the method comprising:
etching a sacrificial layer (262) having a stack of channel layers (120) thereon, wherein a closest one of the channel layers (120) to the sacrificial layer (262) is a dummy channel layer (120d), and wherein etching the sacrificial layer (262) comprises forming (330) an opening (238) in the sacrificial layer (262) that narrows in width as the sacrificial layer (262) approaches the dummy channel layer (120d);
forming (335) a sacrificial contact (240) in the opening (238);
replacing (355) the sacrificial layer (262) with an isolation region (190) , after forming (335) the sacrificial contact (240);
replacing (360) the sacrificial contact (240) with a conductive contact (150a, 150b); and
forming (365) a backside, BS, power rail (160) on the conductive contact (150a, 150b).
